# EUROPEAN PATENT SPECIFICATION

(11) **EP 3 937 385 B1**
(45) Date of publication and mention of the grant of the patent: **08.04.2026**
(21) Application number: 20869154.3
(22) Date of filing: 18.09.2020
(51) Int. Cl.: H04B 1/04, H04B 7/00, H04B 1/00

(54) **DIGITAL UP CONVERSER PROCESSING DEVICE AND INTERMEDIATE FREQUENCY LINK IN WIRELESS COMMUNICATION SYSTEM**
VORRICHTUNG ZUR VERARBEITUNG VON DIGITALEM AUFWÄRTSKONVERTER UND ZWISCHENFREQUENZVERBINDUNG IN DRAHTLOSKOMMUNIKATIONSSYSTEM
DISPOSITIF DE TRAITEMENT DE CONVERSION ASCENDANTE NUMÉRIQUE ET LIAISON DE FRÉQUENCE INTERMÉDIAIRE DANS UN SYSTÈME DE COMMUNICATION SANS FIL

(30) Priority: 29.09.2019 CN 201910935350
(43) Date of publication of application: 12.01.2022
(73) Proprietor: Sanechips Technology Co., Ltd., Shenzhen, Guangdong 518055 (CN)
(72) Inventor: YANG, Li, Shenzhen, Guangdong 518057 (CN); DU, Xin, Shenzhen, Guangdong 518057 (CN); YUN, Lina, Shenzhen, Guangdong 518057 (CN)
(74) Representative: Deambrogi, Edgardo
(86) International application number: PCT/CN2020/116174
(87) International publication number: WO 2021/057617

(56) References cited:
- WO-A1-2007/114599
- CN-A- 101 102 116
- CN-A- 101 257 481
- CN-A- 106 972 833
- CN-A- 107 682 098
- CN-A- 110 098 803
- US-A1- 2002 150 169

## Description

### Technical Field

The present invention relates to the field of wireless communication networks, and for example relates to a digital up conversion processing device and an intermediate frequency link in a wireless communication system.

### Background

A digital up conversion processing device can perform multiple types of power adjustments and rate conversions on an inputted digital signal, achieve modulation and frequency mixing in a digital domain, and output a high-speed digital intermediate frequency signal. In a wireless communication system, some large-bandwidth digital signals sent at a base band can be divided into multiple subband carrier signals, which are then transmitted to an intermediate frequency portion for processing. The digital up conversion processing device generally includes a structure (hereinafter structure I for short) configured to process subband carrier signals and a structure (hereinafter structure II for short) configured to process non-subband carrier signals. The structure I and the structure II are separately provided, causing a high cost and a large volume of the digital up conversion processing device.

CN 106972833A discloses a digital up converter that is able to achieve sampling of any multiples.

### Summary

The embodiments of the present invention provide a digital up conversion processing device, and an intermediate frequency link in a wireless communication system, which can reduce hardware overhead and production costs of the digital up conversion processing device, and achieve low power consumption and miniaturization of the digital up conversion processing device.

The present invention is set out in the independent claims. Further aspects and preferred embodiments are defined in the dependent claims. Aspects, embodiments and examples of the present invention that do not fall within the scope of the appended claims do not form part of the invention and are merely provided for illustrative purposes..

Provided is a digital up conversion processing device, including N main body modules and a combination module, wherein N is a positive integer greater than or equal to 1; each of the N main body modules includes: a gain module, a shaping filtering module, a Digital Up Converter (DUC) module, a first frequency mixing module, and a second frequency mixing module; wherein
an input end of the gain module is configured to input a carrier signal, and an output end of the gain module is connected to an input end of the shaping filtering module and an input end of the DUC module;
an output end of the shaping filtering module is connected to the input end of the DUC module and an input end of the second frequency mixing module;
an output end of the DUC module is connected to an input end of the first frequency mixing module and the input end of the second frequency mixing module;
an output end of the second frequency mixing module is configured to output the carrier signal;
an output end of the first frequency mixing module is connected to an input end of the combination module; and
an output end of the combination module is connected to the input end of the shaping filtering module.

Also provided is an intermediate frequency link in a wireless communication system, wherein the intermediate frequency link includes the described digital up conversion processing device.

### Brief Description of the Drawings

Fig. 1 is a structural schematic diagram of a digital up conversion processing device;
Fig. 2 is a structural schematic diagram of another digital up conversion processing device;
Fig. 3 is a structural schematic diagram of yet another digital up conversion processing device;
Fig. 4 is a structural schematic diagram of a digital up conversion processing device provided in some embodiments; and
Fig. 5 is a structural schematic diagram of another digital up conversion processing device provided in some embodiments.

### Detailed Description

Hereinafter, the embodiments of the present invention will be described in combination with the accompanying drawings.

A digital up conversion processing device is an important component of a transceiver board unit in a radio remote unit (RRU), and main functions of the digital up conversion processing device are to perform multiple types of power adjustments and rate conversions on an inputted digital signal, achieve modulation and frequency mixing in a digital domain, and output a high-speed digital intermediate frequency signal.

Generally, large-bandwidth digital signals sent by a building base band unit (BBU) to an RRU may be divided into multiple subband carrier signals, and signal processing flows for the subband carrier signals and non-subband carrier signals in the digital up conversion processing device are different according to their respective characteristics.

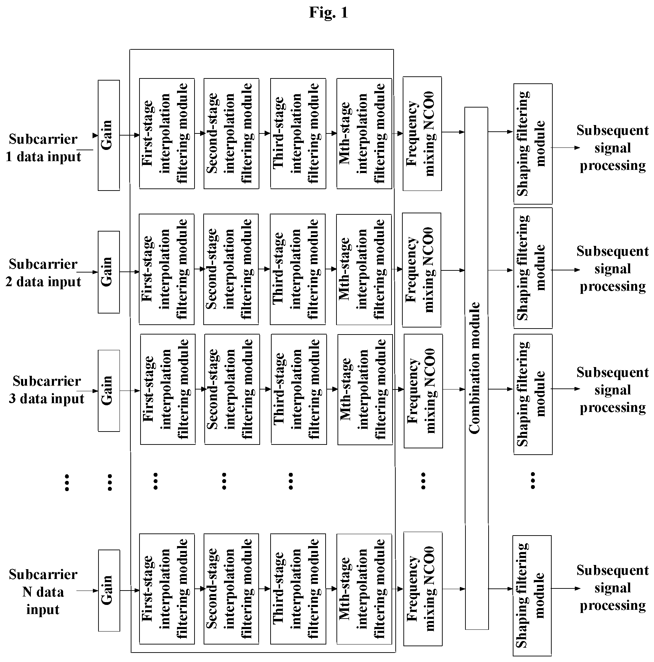

Fig. 1 is a structural schematic diagram of a digital up conversion processing device. The digital up conversion processing device as shown in Fig. 1 is configured to process subband carrier signals. As shown in Fig. 1, the digital up conversion processing device includes: N paths of gains, N paths of multi-stage interpolation filtering modules (also referred to as multi-stage DUC filtering modules, and in Fig. 1 the modules are drawn as M stages as an example), N paths of frequency mixing numerically controlled oscillators (NCOs) 0, a combination module and N paths of shaping filtering modules. When a digital signal is a subband carrier signal, the subband carrier signal first passes through the gain for power adjustment, then passes through the multi-stage interpolation filtering modules to complete digital up conversion processing, and finally passes through the frequency mixing NCO0 and the combination module and enters the shaping filtering module to complete shaping filtering and then is outputted.

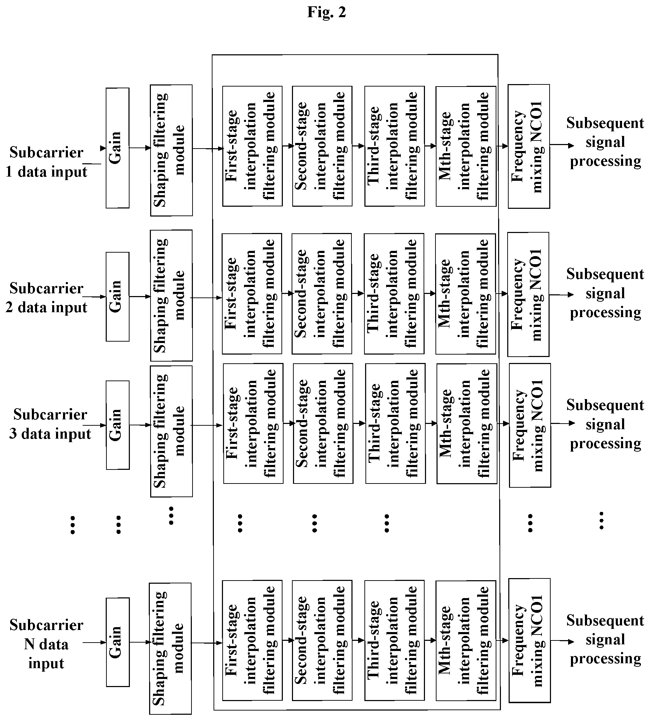

Fig. 2 is a structural schematic diagram of another digital up conversion processing device. The digital up conversion processing device shown in Fig. 2 is configured to process non-subband carrier signals. As shown in Fig. 2, the digital up conversion processing device includes: N paths of gains, N paths of shaping filtering modules, N paths of multi-stage interpolation filtering modules (in Fig. 2 the modules are drawn as M stages as an example) and N paths of frequency mixing NCO1. When the digital signal is a non-subband carrier signal, the non-subband carrier signal first passes through the gain for power adjustment, then passes through the shaping filtering module to complete shaping filtering, and finally sequentially passes through the multi-stage interpolation filtering modules and the frequency mixing NCO1 to complete digital up conversion processing and frequency mixing operations.

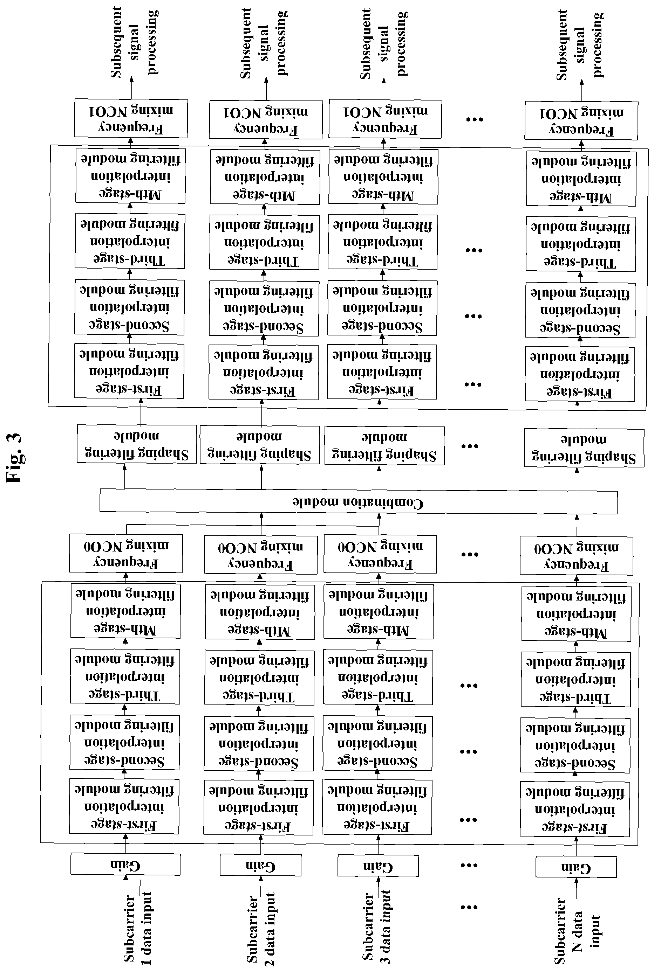

The described two digital up conversion processing devices separately process subband carrier signals and non-subband carrier signals. The processes for data stream processing and timing control are simple, the multiple processes of carrier processing do not affect each other, and the implementation technology is simple. However, when a system needs to be compatible for multi-bandwidth subband carrier signals and non-subband carrier signals, the digital up conversion processing devices as shown in Figs. 1 and 2 cannot satisfy the requirements. Fig. 3 is a structural schematic diagram of yet another digital up conversion processing device. The digital up conversion processing device includes: N paths of gains, N paths of multi-stage interpolation filtering modules 1 (in Fig. 3 the modules are drawn as M stages as an example), N paths of frequency mixing NCO0, a combination module, N paths of shaping filtering modules, N paths of multi-stage interpolation filtering modules 2 (in Fig. 3 the modules are drawn as M stages as an example), and N paths of frequency mixing NCO1. The digital up conversion processing device shown in Fig. 3 also has the advantages of the digital up conversion processing devices as shown in Figs. 1 and 2 when processing subband carrier signals and non-subband carrier signals, that is, the timing control is simple and is easy to implement. However, as shown in Fig. 3, the multi-stage interpolation filtering modules achieving the same function appear twice in the implementation structure, and the disadvantages caused thereby include two aspects: on the one hand, the digital up conversion processing device as shown in Fig. 3 requires more hardware resources and more interpolation filtering modules, but nowadays, as the product requirements develop towards the directions of low power consumption, miniaturization and microminiaturization, the digital up conversion processing device as shown in Fig. 3 cannot meet the requirements; and on the other hand, the digital up conversion processing device as shown in Fig. 3 prolongs the product development time, and a lot of hardware overheads also significantly increase the system power consumption. In a multi-bandwidth multi-carrier communication system, the described disadvantages become more and more fatal and obvious, which weakens the product competitiveness to a great extent.

Embodiments of the present invention provide a digital up conversion processing device, and an intermediate frequency link in a wireless communication system, which can reduce hardware overhead and production costs of the digital up conversion processing device, and achieve low power consumption and miniaturization of the digital up conversion processing device.

The terms "first", "second", "third", and the like herein are used to distinguish different objects, and are not to define a specific sequence. The following multiple embodiments of the present invention may be executed separately, or the multiple embodiments may be executed in combination with each other, which is not limited in the embodiments of the present invention.

Hereinafter, a digital up conversion processing device, an intermediate frequency link in a wireless communication system, and effects thereof are described.

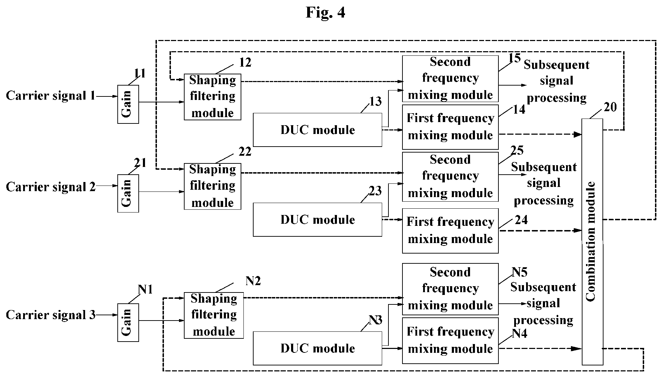

Fig. 4 is a structural schematic diagram of a digital up conversion processing device provided in some embodiments. As shown in Fig. 4, the digital up conversion processing device includes: N main body modules and a combination module 20, wherein N is a positive integer greater than or equal to 1.

Each of the N main body modules includes: a gain module, a shaping filtering module, a DUC module, a first frequency mixing module, and a second frequency mixing module. As shown in Fig. 4, a first main body module includes: a gain module 11, a shaping filtering module 12, a DUC module 13, a first frequency mixing module 14 and a second frequency mixing module 15; a second main body module includes: a gain module 21, a shaping filtering module 22, a DUC module 23, a first frequency mixing module 24 and a second frequency mixing module 25; and by analogy, an Nth main body module includes: a gain module N1, a shaping filtering module N2, a DUC module N3, a first frequency mixing module N4 and a second frequency mixing module N5.

Taking the first main body module as an example, an input end of the gain module 11 inputs a carrier signal, and an output end of the gain module 11 is connected to an input end of the shaping filtering module 12 and an input end of the DUC module 13; an output end of the shaping filtering module 12 is connected to the input end of the DUC module 13 and an input end of the second frequency mixing module 15; an output end of the DUC module 13 is connected to an input end of the first frequency mixing module 14 and the input end of the second frequency mixing module 15; an output end of the second frequency mixing module 15 outputs the carrier signal; an output end of the first frequency mixing module 14 is connected to an input end of the combination module 20; and an output end of the combination module 20 is connected to the input end of the shaping filtering module 12.

The connection relationships of the second main body module, ..., the Nth main body module are similar to the connection relationship of the first main body module, and will not be repeated herein.

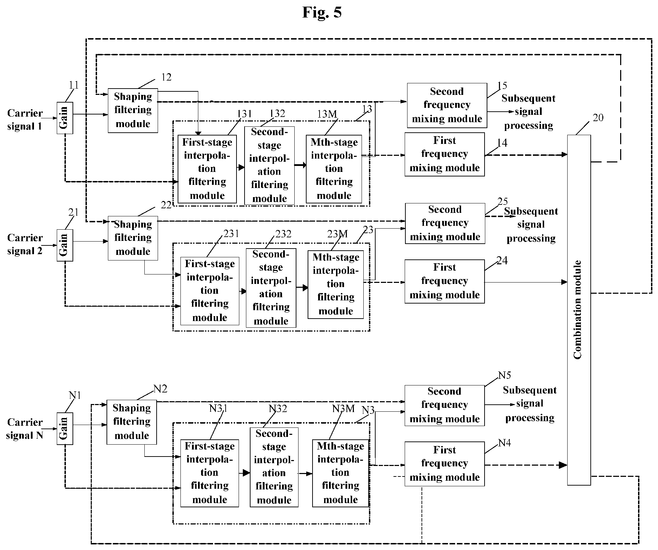

In some embodiments, in combination with Fig. 4, Fig. 5 is a structural schematic diagram of another digital up conversion processing device provided in some embodiments. As shown in Fig. 5, the DUC module includes M interpolation filtering modules connected in series, wherein M is a positive integer greater than or equal to 1. That is, the DUC module 13 includes an interpolation filtering module 131, an interpolation filtering module 132, ..., and an interpolation filtering module 13M; the DUC module 23 includes an interpolation filtering module 231, an interpolation filtering module 232, ..., and an interpolation filtering module 23M; and by analogy, the DUC module N3 includes an interpolation filtering module N31, an interpolation filtering module N32, ..., and an interpolation filtering module N3M.

In some embodiments, the interpolation filtering modules are double interpolation filters. Assuming that an input data rate of the interpolation filtering module 131 is a, output data rates of the interpolation filtering module 131, the interpolation filtering module 132, ..., and the interpolation filtering module 13M are 2a, 4a, ..., 2ma, respectively.

In some embodiments, the filter order and corresponding filter coefficient of each of the shaping filtering modules are built in and can be selected, thereby satisfying performance requirements for processing signals with different bandwidths and different rates.

In some embodiments, the combination module 20 may be a subband combination module. The combination module 20 can combine and add K (K≤N) carriers in N carrier signals according to service requirements and then output the combined carrier signal, and the shaping filtering module which can be connected to the output of the combined carrier signal may be randomly selected from shaping filtering modules connected when the K carriers are outputted without being combined. Figs. 4 and 5 do not reflect a subband carrier combination function, that is, Figs. 4 and 5 show a structure when carriers are not subjected to subband combination.

In some embodiments, if the carrier signal is a subband carrier signal, the gain module is configured to adjust the power of the subband carrier signal and send the subband carrier signal to the DUC module; the DUC module is configured to perform digital up conversion processing on the subband carrier signal, and send the subband carrier signal to the first frequency mixing module; the first frequency mixing module is configured to perform frequency mixing processing on the subband carrier signal, and send the subband carrier signal to the combination module.

The combination module is configured to receive the subband carrier signal and send the subband carrier signal to the shaping filtering module of the main body module corresponding to the subband carrier signal; the shaping filtering module is configured to perform shaping filtering processing on the subband carrier signal, and send the subband carrier signal to the second frequency mixing module; and the second frequency mixing module is configured to perform frequency mixing processing on the subband carrier signal.

Refer to Fig. 5, if a carrier signal 1, a carrier signal 2, ..., and a carrier signal N are subband carrier signals, and the carrier signal 1, the carrier signal 2, ..., and the carrier signal N are not subjected to subband combination, taking the first main body module as an example, a flow direction of the carrier signal 1 is shown by dotted lines in the figure, and in this case, the main body module implements the following functions respectively.

The gain module 11 is configured to adjust the power of the subband carrier signal, and sends the subband carrier signal to the DUC module 13. The DUC module 13 is configured to perform digital up conversion processing on the subband carrier signal, and send the subband carrier signal to the first frequency mixing module 14. The first frequency mixing module 14 is configured to perform frequency mixing processing on the subband carrier signal, and send the subband carrier signal to the combination module 20. The combination module 20 is configured to receive the subband carrier signal, and send the subband carrier signal to the shaping filtering module of the main body module corresponding to the subband carrier signal (that is, send the subband carrier signal 1 to the shaping filtering module 12, send the subband carrier signal 2 to the shaping filtering module 22, ..., and send the subband carrier signal N to the shaping filtering module N2). The shaping filtering module 12 is configured to perform shaping filtering processing on the subband carrier signal, and send the subband carrier signal to the second frequency mixing module 15. The second frequency mixing module 15 is configured to perform frequency mixing processing on the subband carrier signal.

In some embodiments, if the carrier signal is a subband carrier signal, the gain module is configured to adjust the power of the subband carrier signal and send the subband carrier signal to the DUC module. The DUC module is configured to perform digital up conversion processing on the subband carrier signal, and send the subband carrier signal to the first frequency mixing module. The first frequency mixing module is configured to perform frequency mixing processing on the subband carrier signal, and send the subband carrier signal to the combination module.

The combination module is configured to receive N subband carrier signals, add and combine K subband carrier signals to obtain a combined subband carrier signal, and send the combined subband carrier signal to a shaping filtering module of the main body module corresponding to any one subband carrier signal among the K subband carrier signals, wherein K is a positive integer less than or equal to N. The shaping filtering module is configured to perform shaping filtering processing on the combined subband carrier signal, and send the combined subband carrier signal to the second frequency mixing module. The second frequency mixing module is configured to perform frequency mixing processing on the combined subband carrier signal.

The combination module is further configured to send each uncombined subband carrier signal to the shaping filtering module of the main body module corresponding to the uncombined subband carrier signal. The shaping filtering module is further configured to perform shaping filtering processing on the uncombined subband carrier signal, and send the uncombined subband carrier signal to the second frequency mixing module. The second frequency mixing module is further configured to perform frequency mixing processing on the uncombined subband carrier signal.

Refer to Fig. 5, if the carrier signal 1, the carrier signal 2, ..., and the carrier signal N are subband carrier signals, and the carrier signal 1 and the carrier signal 2 are subjected to subband combination, and the carrier signal 3, ..., and the carrier signal N are not subjected to subband combination, by taking the first main body module, the second main body module, and the Nth main body module as an example, flow directions of the carrier signal 1, the carrier signal 2, and the carrier signal N are shown by dotted lines in the figure, and at this time, the main body modules respectively implement the following functions.

The gain module 11 is configured to adjust the power of the subband carrier signal, and send the subband carrier signal to the DUC module 13. The DUC module 13 is configured to perform digital up conversion processing on the subband carrier signal, and send the subband carrier signal to the first frequency mixing module 14. The first frequency mixing module 14 is configured to perform frequency mixing processing on the subband carrier signal, and send the subband carrier signal to the combination module 20.

The gain module 21 is configured to adjust the power of the subband carrier signal, and send the subband carrier signal to the DUC module 23. The DUC module 23 is configured to perform digital up conversion processing on the subband carrier signal, and send the subband carrier signal to the first frequency mixing module 24. The first frequency mixing module 24 is configured to perform frequency mixing processing on the subband carrier signal, and send the subband carrier signal to the combination module 20.

The gain module N1 is configured to adjust the power of the subband carrier signal, and send the subband carrier signal to the DUC module N3. The DUC module N3 is configured to perform digital up conversion processing on the subband carrier signal, and send the subband carrier signal to the first frequency mixing module N4. The first frequency mixing module N4 is configured to perform frequency mixing processing on the subband carrier signal, and send the subband carrier signal to the combination module 20.

The combination module 20 is configured to receive N subband carrier signals, add and combine the carrier signal 1 and the carrier signal 2 to obtain a combined subband carrier signal, and send the combined subband carrier signal to the shaping filtering module 12 or the shaping filtering module 22 (in some embodiments of the present invention, the combined subband carrier signal is sent to the shaping filtering module 12 for illustration). In addition, the combination module 20 is further configured to send each uncombined subband carrier signal to the shaping filtering module of the main body module corresponding to the uncombined subband carrier signal (that is, send the subband carrier signal 3 to the shaping filtering module 32, ..., and send the subband carrier signal N to the shaping filtering module N2).

The shaping filtering module 12 is configured to perform shaping filtering processing on the combined subband carrier signal, and send the combined subband carrier signal to the second frequency mixing module 15. The second frequency mixing module 15 is configured to perform frequency mixing processing on the combined subband carrier signal.

The shaping filtering module N2 is configured to perform shaping filtering processing on the uncombined subband carrier signal, and send the uncombined subband carrier signal to the second frequency mixing module N5. The second frequency mixing module N5 is configured to perform frequency mixing processing on the uncombined subband carrier signal.

In some embodiments, if the carrier signal is a non-subband carrier signal, the gain module is configured to adjust the power of the non-subband carrier signal and send the non-subband carrier signal to the shaping filtering module, the shaping filtering module is configured to perform shaping filtering processing on the non-subband carrier signal, and send the non-subband carrier signal to the DUC module. The DUC module is configured to perform digital up conversion processing on the non-subband carrier signal, and send the non-subband carrier signal to the second frequency mixing module. The second frequency mixing module is configured to perform frequency mixing processing on the non-subband carrier signal.

Refer to Fig. 5, if the carrier signal 1, the carrier signal 2, ..., and the carrier signal N are non-subband carrier signals, taking the first main body module as an example, a flow direction of the carrier signal 1 is shown by solid lines in the figure, and in this case, the main body module implements the following functions respectively.

The gain module 11 is configured to adjust the power of the non-subband carrier signal, and send the non-subband carrier signal to the shaping filtering module 12. The shaping filtering module 12 is configured to perform shaping filtering processing on the non-subband carrier signal, and send the non-subband carrier signal to the DUC module 13. The DUC module 13 is configured to perform digital up conversion processing on the non-subband carrier signal, and send the non-subband carrier signal to the second frequency mixing module 15. The second frequency mixing module 15 is configured to perform frequency mixing processing on the non-subband carrier signal.

The embodiments of the present invention provide a digital up conversion processing device, including N main body modules and a combination module, wherein N is a positive integer greater than or equal to 1. Each of the N main body modules includes: a gain module, a shaping filtering module, a DUC module, a first frequency mixing module, and a second frequency mixing module. An input end of the gain module inputs a carrier signal, and an output end of the gain module is connected to an input end of the shaping filtering module and an input end of the DUC module. An output end of the shaping filtering module is connected to the input end of the DUC module and an input end of the second frequency mixing module. An output end of the DUC module is connected to an input end of the first frequency mixing module and the input end of the second frequency mixing module. An output end of the second frequency mixing module outputs a carrier signal. An output end of the first frequency mixing module is connected to an input end of the combination module; and an output end of the combination module is connected to the input end of the shaping filtering module. Compared with the digital up conversion processing device in the related art, the DUC module is multiplexed while processing both multi-bandwidth subband carrier signals and non-subband carrier signals, which reduces hardware overhead and production costs of the digital up conversion processing device, and achieves low power consumption and miniaturization of the digital up conversion processing device.

The embodiments of the present invention also provide an intermediate frequency link in a wireless communication system. The intermediate frequency link includes the digital up conversion processing device provided in any embodiment of the present invention. The implementation principle and effect of the intermediate frequency link in a wireless communication system provided in this embodiment are similar to those of the described digital up conversion processing device, and will not be repeated herein.

In some embodiments, the digital up conversion processing device is located on a transceiver board unit of the intermediate frequency link in a wireless communication system.

The described content merely relates to exemplary embodiments of the present invention, and is not intended to limit the scope of protection of some embodiments of the present invention. In general, the multiple embodiments of the present invention may be implemented in hardware or dedicated circuit, software, logic, or any combination thereof. For example, some aspects may be implemented in hardware, while other aspects may be implemented in firmware or software that may be executed by a controller, a microprocessor or other computing devices, although the present invention is not limited thereto.

## Claims

1. A digital up conversion processing device, comprising: N main body modules and a combination module (20), wherein N is a positive integer greater than or equal to 1; each of the N main body modules comprises: a gain module (11; 21; N1), a shaping filtering module (12; 22; N2), a Digital Up Converter, DUC, module (13; 23; N3), a first frequency mixing module (14; 24; N4), and a second frequency mixing module (15; 25; N5); wherein
an input end of the gain module (11; 21; N1) is configured to input a carrier signal, and an output end of the gain module (11; 21; N1) is connected to an input end of the shaping filtering module (12; 22; N2) and an input end of the DUC module (13; 23; N3);
an output end of the shaping filtering module (12; 22; N2) is connected to the input end of the DUC module (13; 23; N3) and an input end of the second frequency mixing module;
an output end of the DUC module (13; 23; N3) is connected to an input end of the first frequency mixing module (14; 24; N4) and the input end of the second frequency mixing module (15; 25; N5);
an output end of the second frequency mixing module (15; 25; N5) is configured to output the carrier signal;
an output end of the first frequency mixing module (14; 24; N4) is connected to an input end of the combination module (20); and
an output end of the combination module (20) is connected to the input end of the shaping filtering module (12; 22; N2).

2. The digital up conversion processing device according to claim 1, wherein the DUC module (13; 23; N3) comprises M interpolation filtering modules (131, 132, 13M; 231, 232, 23M; N31, N32, N3M) connected in series, wherein M is a positive integer greater than or equal to 1.

3. The digital up conversion processing device according to claim 2, wherein each of the M interpolation filtering modules (131, 132, 13M; 231, 232, 23M; N31, N32, N3M) is a double interpolation filter.

4. The digital up conversion processing device according to claim 1, wherein
the digital up conversion processing device is configured so that, in cases where the carrier signal is a subband carrier signal, the gain module (11, 21, N1) is configured to adjust the power of the subband carrier signal and send the subband carrier signal to the DUC module (13; 23; N3);
the DUC module (13; 23; N3) is configured to perform digital up conversion processing on the subband carrier signal, and send the subband carrier signal to the first frequency mixing module (14; 24; N4); and
the first frequency mixing module (14; 24; N4) is configured to perform frequency mixing processing on the subband carrier signal, and send the subband carrier signal to the combination module (20).

5. The digital up conversion processing device according to claim 4, wherein
the combination module (20) is configured to receive the subband carrier signal and send the subband carrier signal to the shaping filtering module (12; 22; N2) of the main body module corresponding to the subband carrier signal;
the shaping filtering module (12; 22; N2) is configured to perform shaping filtering processing on the subband carrier signal, and send the subband carrier signal to the second frequency mixing module (15; 25; N5); and
the second frequency mixing module (15; 25; N5) is configured to perform frequency mixing processing on the subband carrier signal.

6. The digital up conversion processing device according to claim 4, wherein
the combination module (20) is configured to receive N subband carrier signals, add and combine K subband carrier signals in the N subband carrier signals to obtain a combined subband carrier signal, and send the combined subband carrier signal to the shaping filtering module (12; 22; N2) of the main body module corresponding to one subband carrier signal among the K subband carrier signals, wherein K is a positive integer less than or equal to N;
the shaping filtering module (12; 22; N2) is configured to perform shaping filtering processing on the combined subband carrier signal, and send the combined subband carrier signal to the second frequency mixing module (15; 25; N5); and
the second frequency mixing module (15; 25; N5) is configured to perform frequency mixing processing on the combined subband carrier signal.

7. The digital up conversion processing device according to claim 6, wherein
the combination module (20) is further configured to send each uncombined subband carrier signal to the shaping filtering module (12; 22; N2) of the main body module corresponding to the uncombined subband carrier signal;
the shaping filtering module (12; 22; N2) is further configured to perform shaping filtering processing on the uncombined subband carrier signal, and send the uncombined subband carrier signal to the second frequency mixing module (15; 25; N5); and
the second frequency mixing module (15; 25; N5) is configured to perform frequency mixing processing on the uncombined subband carrier signal.

8. The digital up conversion processing device according to claim 1, wherein
the digital up conversion processing device is configured so that, in cases where the carrier signal is a non-subband carrier signal, the gain module (11, 21, N1) is configured to adjust the power of the non-subband carrier signal and send the non-subband carrier signal to the shaping filtering module (12; 22; N2);
the shaping filtering module (12; 22; N2) is configured to perform shaping filtering processing on the non-subband carrier signal, and send the non-subband carrier signal to the DUC module (13; 23; N3);
the DUC module (13; 23; N3) is configured to perform digital up conversion processing on the non-subband carrier signal, and send the non-subband carrier signal to the second frequency mixing module (15; 25; N5); and
the second frequency mixing module (15; 25; N5) is configured to perform frequency mixing processing on the non-subband carrier signal.

9. The digital up conversion processing device according to claim 1, wherein the filter order and corresponding filter coefficient of any shaping filtering module (12; 22; N2) are built in and are able to be selected.

10. A wireless communication system comprising an intermediate frequency link, wherein the intermediate frequency link comprises the digital up conversion processing device according to any one of claims 1-9.

11. The wireless communication system according to claim 10, wherein the digital up conversion processing device is located on a transceiver board unit of the intermediate frequency link in a wireless communication system.

## Patentansprüche

1. Vorrichtung zur Verarbeitung von digitaler Aufwärtskonvertierung, umfassend: N Hauptkörpermodule und ein Kombinationsmodul (20), wobei N eine positive ganze Zahl größer als oder gleich 1 ist; jedes der N Hauptkörpermodule umfasst: ein Verstärkungsmodul (11; 21; N1), ein Formfiltermodul (12; 22; N2), einen digitalen Aufwärtskonverter, DUC, Modul (13; 23; N3), ein erstes Frequenzmischmodul (14; 24; N4), und ein zweites Frequenzmischmodul (15; 25; N5); wobei
ein Eingabeende des Verstärkungsmoduls (11; 21; N1) dazu konfiguriert ist, ein Trägersignal einzugeben, und ein Ausgabeende des Verstärkungsmoduls (11; 21; N1) mit einem Eingabeende des Formfiltermoduls (12; 22; N2) und einem Eingabeende des DUC-Moduls (13; 23; N3) verbunden ist;
ein Ausgabeende des Formfiltermoduls (12; 22; N2) mit dem Eingabeende des DUC-Moduls (13; 23; N3) und mit einem Eingabeende des zweiten Frequenzmischmoduls verbunden ist;
ein Ausgabeende des DUC-Moduls (13; 23; N3) mit einem Eingabeende des ersten Frequenzmischmoduls (14; 24; N4) und mit dem Eingabeende des zweiten Frequenzmischmoduls (15; 25; N5) verbunden ist;
ein Ausgabeende des zweiten Frequenzmischmoduls (15; 25; N5) dazu konfiguriert ist, das Trägersignal auszugeben;
ein Ausgabeende des ersten Frequenzmischmoduls (14; 24; N4) mit einem Eingabeende des Kombinationsmoduls (20) verbunden ist; und
ein Ausgabeende des Kombinationsmoduls (20) mit dem Eingabeende des Formfiltermoduls (12; 22; N2) verbunden ist.

2. Vorrichtung zur Verarbeitung von digitaler Aufwärtskonvertierung nach Anspruch 1, wobei das DUC-Modul (13; 23; N3) M Interpolationsfiltermodule (131, 132, 13M; 231, 232, 23M; N31, N32, N3M) umfasst, die in Reihe geschaltet sind, wobei M eine positive ganze Zahl größer als oder gleich 1 ist.

3. Vorrichtung zur Verarbeitung von digitaler Aufwärtskonvertierung nach Anspruch 2, wobei jedes der M Interpolationsfiltermodule (131, 132, 13M; 231, 232, 23M; N31, N32, N3M) ein Doppelinterpolationsfilter ist.

4. Vorrichtung zur Verarbeitung von digitaler Aufwärtskonvertierung nach Anspruch 1, wobei
die Vorrichtung zur Verarbeitung von digitaler Aufwärtskonvertierung dazu konfiguriert ist, sodass, wenn das Trägersignal ein Unterband-Trägersignal ist, das Verstärkungsmodul (11, 21, N1) dazu konfiguriert ist, um
die Leistung des Unterband-Trägersignals einzustellen und das Unterband-Trägersignal an das DUC-Modul (13; 23; N3) zu senden;
das DUC-Modul (13; 23; N3) dazu konfiguriert ist, um
eine digitale Aufwärtskonvertierungsverarbeitung an dem Unterband-Trägersignal durchzuführen und das Unterband-Trägersignal an das erste Frequenzmischmodul (14; 24; N4) zu senden; und
das erste Frequenzmischmodul (14; 24; N4) dazu konfiguriert ist, um
eine Frequenzmischverarbeitung an dem Unterband-Trägersignal durchzuführen und das Unterband-Trägersignal an das Kombinationsmodul (20) zu senden.

5. Vorrichtung zur Verarbeitung von digitaler Aufwärtskonvertierung nach Anspruch 4, wobei
das Kombinationsmodul (20) dazu konfiguriert ist, das Unterband-Trägersignal zu empfangen und das Unterband-Trägersignal an das Formfiltermodul (12; 22; N2) des Hauptkörpermoduls, das dem Unterband-Trägersignal entspricht, zu senden;
das Formfiltermodul (12; 22; N2) dazu konfiguriert ist, eine Formfilterverarbeitung an dem Unterband-Trägersignal durchzuführen und das Unterband-Trägersignal an das zweite Frequenzmischmodul (15; 25; N5) zu senden; und
das zweite Frequenzmischmodul (15; 25; N5) dazu konfiguriert ist, eine Frequenzmischverarbeitung an dem Unterband-Trägersignal durchzuführen.

6. Vorrichtung zur Verarbeitung von digitaler Aufwärtskonvertierung nach Anspruch 4, wobei
das Kombinationsmodul (20) dazu konfiguriert ist, N Unterband-Trägersignale zu empfangen, K Unterband-Trägersignale in den N Unterband-Trägersignalen zu addieren und zu kombinieren, um ein kombiniertes Unterband-Trägersignal zu erhalten, und das kombinierte Unterband-Trägersignal an das Formfiltermodul (12; 22; N2) des Hauptkörpermoduls, das einem Unterband-Trägersignal unter den K Unterband-Trägersignalen entspricht, zu senden, wobei K eine positive ganze Zahl kleiner als oder gleich N ist;
das Formfiltermodul (12; 22; N2) dazu konfiguriert ist, eine Formfilterverarbeitung an dem kombinierten Unterband-Trägersignal durchzuführen und das kombinierte Unterband-Trägersignal an das zweite Frequenzmischmodul (15; 25; N5) zu senden; und
das zweite Frequenzmischmodul (15; 25; N5) dazu konfiguriert ist, eine Frequenzmischverarbeitung an dem kombinierten Unterband-Trägersignal durchzuführen.

7. Vorrichtung zur Verarbeitung von digitaler Aufwärtskonvertierung nach Anspruch 6, wobei
das Kombinationsmodul (20) ferner dazu konfiguriert ist, jedes unkombinierte Unterband-Trägersignal an das Formfiltermodul (12; 22; N2) des Hauptkörpermoduls, das dem unkombinierten Unterband-Trägersignal entspricht, zu senden;
das Formfiltermodul (12; 22; N2) ferner dazu konfiguriert ist, eine Formfilterverarbeitung an dem unkombinierten Unterband-Trägersignal durchzuführen und das unkombinierte Unterband-Trägersignal an das zweite Frequenzmischmodul (15; 25; N5) zu senden; und
das zweite Frequenzmischmodul (15; 25; N5) dazu konfiguriert ist, eine Frequenzmischverarbeitung an dem unkombinierten Unterband-Trägersignal durchzuführen.

8. Vorrichtung zur Verarbeitung von digitaler Aufwärtskonvertierung nach Anspruch 1, wobei die Vorrichtung zur Verarbeitung von digitaler Aufwärtskonvertierung dazu konfiguriert ist, sodass, in Fällen, wenn das Trägersignal ein Nicht-Unterband-Trägersignal ist, das Verstärkungsmodul (11, 21, N1) dazu konfiguriert ist, um
die Leistung des Nicht-Unterband-Trägersignals einzustellen und das Nicht-Unterband-Trägersignal an das Formfiltermodul (12; 22; N2) zu senden;
das Formfiltermodul (12; 22; N2) dazu konfiguriert ist, um
eine Formfilterverarbeitung an dem Nicht-Unterband-Trägersignal durchzuführen und das Nicht-Unterband-Trägersignal an das DUC-Modul (13; 23; N3) zu senden;
das DUC-Modul (13; 23; N3) dazu konfiguriert ist,
eine digitale Aufwärtskonvertierungsverarbeitung an dem Nicht-Unterband-Trägersignal durchzuführen und das Nicht-Unterband-Trägersignal an das zweite Frequenzmischmodul (15; 25; N5) zu senden; und
das zweite Frequenzmischmodul (15; 25; N5) dazu konfiguriert ist, um
eine Frequenzmischverarbeitung an dem Nicht-Unterband-Trägersignal durchzuführen.

9. Vorrichtung zur Verarbeitung von digitaler Aufwärtskonvertierung nach Anspruch 1, wobei die Filterordnung und der entsprechende Filterkoeffizient eines beliebigen Formfiltermoduls (12; 22; N2) integriert sind und in der Lage sind, ausgewählt zu werden.

10. Drahtloskommunikationssystem, umfassend eine Zwischenfrequenzverbindung, wobei die Zwischenfrequenzverbindung die Vorrichtung zur Verarbeitung von digitaler Aufwärtskonvertierung nach einem der Ansprüche 1 bis 9 umfasst.

11. Drahtloskommunikationssystem nach Anspruch 10, wobei die Vorrichtung zur Verarbeitung von digitaler Aufwärtskonvertierung auf einer Sender-Empfänger-Platineneinheit der Zwischenfrequenzverbindung in einem Drahtloskommunikationssystem angeordnet ist.

## Revendications

1. Dispositif de traitement de conversion ascendante numérique, comprenant : N modules de corps principal et un module de combinaison (20), dans lequel N est un entier positif supérieur ou égal à 1 ; chacun des N modules de corps principal comprend : un module de gain (11 ; 21 ; N1), un module de filtrage de mise en forme (12 ; 22 ; N2), un module de convertisseur numérique ascendant, DUC, (13 ; 23 ; N3), un premier module de mélange de fréquence (14 ; 24 ; N4), et un second module de mélange de fréquence (15 ; 25 ; N5) ; dans lequel
une extrémité d'entrée du module de gain (11 ; 21 ; N1) est configurée pour introduire un signal porteuse, et une extrémité de sortie du module de gain (11 ; 21 ; N1) est reliée à une extrémité d'entrée du module de filtrage de mise en forme (12 ; 22 ; N2) et à une extrémité d'entrée du module DUC (13 ; 23 ; N3) ;
une extrémité de sortie du module de filtrage de mise en forme (12 ; 22 ; N2) est reliée à l'extrémité d'entrée du module DUC (13 ; 23 ; N3) et à une extrémité d'entrée du second module de mélange de fréquence ;
une extrémité de sortie du module DUC (13 ; 23 ; N3) est reliée à une extrémité d'entrée du premier module de mélange de fréquence (14 ; 24 ; N4) et à l'extrémité d'entrée du second module de mélange de fréquence (15 ; 25 ; N5) ; une extrémité de sortie du second module de mélange de fréquence (15 ; 25 ; N5) est configurée pour émettre le signal porteuse;
une extrémité de sortie du premier module de mélange de fréquence (14 ; 24 ; N4) est reliée à une extrémité d'entrée du module de combinaison (20) ; et
une extrémité de sortie du module de combinaison (20) est reliée à l'extrémité d'entrée du module de filtrage de mise en forme (12 ; 22 ; N2).

2. Dispositif de traitement de conversion ascendante numérique selon la revendication 1, dans lequel le module DUC (13 ; 23 ; N3) comprend M modules de filtrage d'interpolation (131, 132, 13M ; 231, 232, 23M ; N31, N32, N3M) reliés en série, dans lequel M est un entier positif supérieur ou égal à 1.

3. Dispositif de traitement de conversion ascendante numérique selon la revendication 2, dans lequel chacun des M modules de filtrage d'interpolation (131, 132, 13M, 231, 232, 23M ; N31, N32, N3M) est un filtre à double interpolation.

4. Dispositif de traitement de conversion ascendante numérique selon la revendication 1, dans lequel
le dispositif de traitement de conversion ascendante numérique est configuré de telle sorte que, dans des cas où le signal porteuse est un signal porteuse de sous-bande, le module de gain (11, 21, N1) est configuré pour
ajuster la puissance du signal porteuse de sous-bande et envoyer le signal porteuse de sous-bande au module DUC (13 ; 23 ; N3) ;
le module DUC (13 ; 23 ; N3) est configuré pour
effectuer un traitement de conversion ascendante numérique sur le signal porteuse de sous-bande, et envoyer le signal porteuse de sous-bande au premier module de mélange de fréquence (14 ; 24 ; N4) ; et
le premier module de mélange de fréquence (14 ; 24 ; N4) est configuré pour
effectuer un traitement de mélange de fréquence sur le signal porteuse de sous-bande, et envoyer le signal porteuse de sous-bande au module de combinaison (20).

5. Dispositif de traitement de conversion ascendante numérique selon la revendication 4, dans lequel
le module de combinaison (20) est configuré pour recevoir le signal porteuse de sous-bande et envoyer le signal porteuse de sous-bande au module de filtrage de mise en forme (12 ; 22 ; N2) du module de corps principal correspondant au signal porteuse de sous-bande ;
le module de filtrage de mise en forme (12 ; 22 ; N2) est configuré pour effectuer un traitement de filtrage de mise en forme sur le signal porteuse de sous-bande, et envoyer le signal porteuse de sous-bande au second module de mélange de fréquence (15 ; 25 ; N5) ; et
le second module de mélange de fréquence (15 ; 25 ; N5) est configuré pour effectuer un traitement de mélange de fréquence sur le signal porteuse de sous-bande.

6. Dispositif de traitement de conversion ascendante numérique selon la revendication 4, dans lequel
le module de combinaison (20) est configuré pour recevoir N signaux porteuse de sous-bande, additionner et combiner K signaux porteuse de sous-bande parmi les N signaux porteuse de sous-bande afin d'obtenir un signal porteuse de sous-bande combiné, et envoyer le signal porteuse de sous-bande combiné au module de filtrage de mise en forme (12 ; 22 ; N2) du module de corps principal correspondant à un signal porteuse de sous-bande parmi les K signaux porteuse de sous-bande, dans lequel K est un entier positif inférieur ou égal à N ;
le module de filtrage de mise en forme (12 ; 22 ; N2) est configuré pour effectuer un traitement de filtrage de mise en forme sur le signal porteuse de sous-bande combiné, et envoyer le signal porteuse de sous-bande combiné au second module de mélange de fréquence (15 ; 25 ; N5) ; et
le second module de mélange de fréquence (15 ; 25 ; N5) est configuré pour effectuer un traitement de mélange de fréquence sur le signal porteuse de sous-bande combiné.

7. Dispositif de traitement de conversion ascendante numérique selon la revendication 6, dans lequel
le module de combinaison (20) est en outre configuré pour envoyer chaque signal porteuse de sous-bande non combiné au module de filtrage de mise en forme (12 ; 22 ; N2) du module de corps principal correspondant au signal porteuse de sous-bande non combiné;
le module de filtrage de mise en forme (12 ; 22 ; N2) est en outre configuré pour effectuer un traitement de filtrage de mise en forme sur le signal porteuse de sous-bande non combiné, et envoyer le signal porteuse de sous-bande non combiné au second module de mélange de fréquence (15 ; 25 ; N5) ; et
le second module de mélange de fréquence (15 ; 25 ; N5) est configuré pour effectuer un traitement de mélange de fréquence sur le signal porteuse de sous-bande non combiné.

8. Dispositif de traitement de conversion ascendante numérique selon la revendication 1, dans lequel le dispositif de traitement de conversion ascendante numérique est configuré de telle sorte que, dans des cas où le signal porteuse est un signal porteuse non de sous-bande, le module de gain (11, 21, N1) est configuré pour ajuster la puissance du signal porteuse non de sous-bande et envoyer le signal porteuse non de sous-bande au module de filtrage de mise en forme (12 ; 22 ; N2) ;
le module de filtrage de mise en forme (12 ; 22 ; N2) est configuré pour
effectuer un traitement de filtrage de mise en forme sur le signal porteuse non de sous-bande, et envoyer le signal porteuse non de sous-bande au module DUC (13 ; 23 ; N3) ;
le module DUC (13 ; 23 ; N3) est configuré pour
effectuer un traitement de conversion ascendante numérique sur le signal porteuse non de sous-bande, et envoyer le signal porteuse non de sous-bande au second module de mélange de fréquence (15 ; 25 ; N5) ; et
le second module de mélange de fréquence (15 ; 25 ; N5) est configuré pour
effectuer un traitement de mélange de fréquence sur le signal porteuse non de sous-bande.

9. Dispositif de traitement de conversion ascendante numérique selon la revendication 1, dans lequel l'ordre de filtre et le coefficient de filtre correspondant de tout module de filtrage de mise en forme (12 ; 22 ; N2) sont intégrés et peuvent être sélectionnés.

10. Système de communication sans fil comprenant une liaison de fréquence intermédiaire, dans lequel la liaison de fréquence intermédiaire comprend le dispositif de traitement de conversion ascendante numérique selon l'une quelconque des revendications 1-9.

11. Système de communication sans fil selon la revendication 10, dans lequel le dispositif de traitement de conversion ascendante numérique est situé sur une unité de carte émetteur-récepteur de la liaison de fréquence intermédiaire dans un système de communication sans fil.
